## Europäisches Patentamt

## European Patent Office

## Office européen des brevets

(11) Publication number: **0 159 546**
**B1**

# EUROPEAN PATENT SPECIFICATION

(45) Date of publication of patent specification: **31.05.89**

(51) Int. Cl.⁴: **H 04 R 27/00, H 03 G 5/18**

(21) Application number: **85103312.6**

(22) Date of filing: **21.03.85**

(54) Digital graphic equalizer.

(30) Priority: **24.03.84 JP 56874/84**

(43) Date of publication of application:
**30.10.85 Bulletin 85/44**

(45) Publication of the grant of the patent:
**31.05.89 Bulletin 89/22**

(84) Designated Contracting States:
**DE FR GB NL**

(56) References cited:
**WO-A-81/02658**
**GB-A-2 068 678**

**AUDIO ENGINEERING SOCIETY PREPRINT, presented at the 67th convention, 31st October - 3rd November 1980, New York, US, pages 1-16; R.W. ADAMS: "An automatic equalizer/analyzer"**

**JOURNAL OF THE AUDIO ENGINEERING SOCIETY, vol. 29, no. 5, May 1981, pages 333-337, New York, US; Y. HIRATA: "Digitalization of conventional analog filters for recording use"**

(73) Proprietor: **SONY CORPORATION**
**7-35 Kitashinagawa 6-Chome Shinagawa-ku Tokyo 141 (JP)**

(72) Inventor: **Kitazato, Naohisa**
**c/o Sony Corporation 7-35 Kitashinagawa 6-chome**
**Shinagawa-ku Tokyo (JP)**
Inventor: **Hamada, Osamu**
**c/o Sony Corporation 7-35 Kitashinagawa 6-chome**
**Shinagawa-ku Tokyo (JP)**

(74) Representative: **Patentanwälte TER MEER - MÜLLER - STEINMEISTER**
**Mauerkircherstrasse 45**
**D-8000 München 80 (DE)**

(56) References cited:
**JOURNAL OF THE AUDIO ENGINEERING SOCIETY, vol. 31, no. 1/2, January/February 1983, pages 25-28, New York, US; S. TAKAHASHI et al.: "Graphic equalizer with microprocessor"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Field of the invention

This invention relates generally to a digital graphic equalizer and particularly to a digital graphic equalizer which is used for processing a digitized audio signal by a desired frequency characteristic.

GB—A—20 68 678 discloses an automatic closed-loop system for providing tone equalization in which either a noise generator, for example a so-called pink noise generator, or an audio signal from a preamplifier are supplied to a digitally controlled multi-band equalizer unit for imposing a specific filter characteristic which signal is then emitted to an environment, for example a room, via a speaker system for accommodating the acoustical effects of the listening environment and for achieving a desired flat frequency response. The equalizer system is provided with means, for example with a microphone followed by a preamplifier, for detecting the measuring noise signal the frequency response of which has been changed in said listening environment. The detected signal is supplied to a second digitally controlled signal processor means for producing a plurality of frequency divided signals, and a microprocessor implemented spectrum analyzer device receives said plurality of frequency divided signals so as to analyze the frequency response of the detected measuring noise signal. The frequency characteristic can be adjusted via a keyboard and a graphic display is provided for giving the user an indication about the adjusted frequency response of an audio equipment provided in said environment.

Similar digitally controlled graphic equalizers including analogue filter elements are described in Audio Engineering Society Reprint, presented at the 67th Convention, 31st October to 3rd November, 1980, pages 1 to 16 and in Journal of the Audio Engineering Society, Vol. 31, No. 1/2, 1983, pages 25—28.

Following suggestions given by Y. Hirata in cooperation with Sony Corporation in Journal of the Audio Engineering Society, Vol. 29, No. 5, 1981, pages 333 to 337, it is also known to digitize an audio signal and to arithmetically process such digital signal in accordance with the frequency characteristics of various filters.

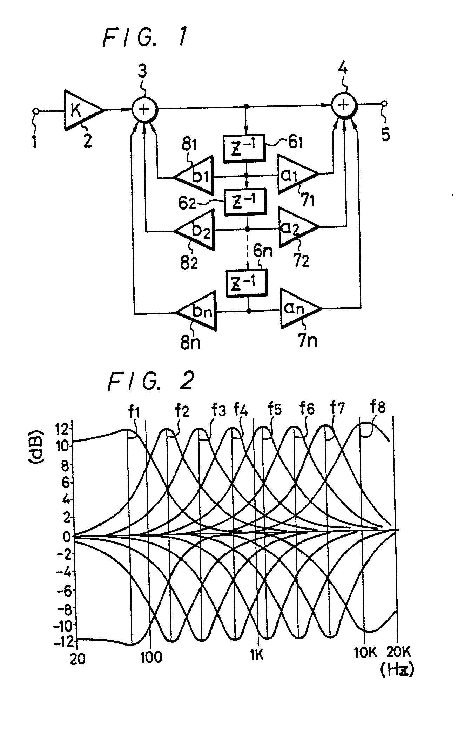

Figure 1 illustrates an example of such prior art digital graphic equalizer. Referring to Figure 1, a digital audio signal applied to an input terminal 1 is delivered through a multiplier 2 having a multiplication coefficient K, an input adder 3 and an output adder 4 to an output terminal 5. The signal between the input and output adders 3 and 4 is supplied to a circuit formed by connecting in cascade delay circuits $6_1, 6_2 \ldots 6_n$ each of which has a delay amount $Z^{-1}$. The outputs from these delay circuits $6_1$ to $6_n$ are respectively supplied through multipliers $7_1, 7_2 \ldots 7_n$ having multiplication coefficients $a_1, a_2 \ldots a_n$ to the above-described output adder 4. Further, the outputs from the delay circuits $6_1, 6_2 \ldots 6_n$ are respectively supplied through multipliers $8_1, 8_2 \ldots 8_n$ having multiplication coefficients $b_1, b_2 \ldots b_n$ to the above-described input adder 3.

In this circuit arrangement, the transfer function from the input terminal 1 to the output terminal 5 is expressed as

$$H(z^{-1})=K \cdot \frac{1+ \sum\limits_{i=0}^{n} a_i Z^{-i}}{1- \sum\limits_{i=0}^{n} b_i Z^{-i}} \qquad (1)$$

Accordingly, various filter characteristics or filter characteristics of desired filters such as a low-pass filter, a high-pass filter, a band-pass filter or the like can be obtained by varying the above-mentioned coefficients K, $a_1$ to $a_n$ and $b_1$ to $b_n$.

As a result, if the above-mentioned circuit is connected in cascade in a plurality of stages (for example, 8 stages), and the characteristics of the respective circuits are made such that, as shown in Figure 2, peak characteristics are obtained at desired resonance frequencies $f_1$ to $f_8$ and the levels at the resonance frequencies $f_1$ to $f_8$ can be adjusted independently, a so-called digital graphic equalizer can be formed.

With a digital graphic equalizer of this type, since all the signal processings are carried out in a digital fashion, when a PCM (pulse code modulated) audio signal and the like signals are processed, the tone quality is not deteriorated unlike the prior art analog signal processing. The signal processing being carried out accurately and easily.

For example, the above-described digital graphic equalizer is used to obtain an equalizer frequency characteristic which is flat in accordance with a listening environment such as a listening room in which an apparatus is installed. However, since the interior room of a vehicle, a listening room of a house and so on are different in acoustic characteristic, different equalizer characteristics are required.

Therefore, it is considered that the acoustic characteristic of the listening environment in which the apparatus is installed is measured, a sound field compensating characteristic for the listening environment is provided and then this compensating characteristic is automatically set at the above-described digital graphic equalizer.

However, in order to measure the acoustic characteristic, a so-called pink noise (noise with frequency characteristic the frequency level of which is lowered with a ratio of 3 dB/oct.) is emitted from a loudspeaker and then collected by a microphone provided at a predetermined place and the collected signal is analyzed by a spectrum analyzer. Of course, this needs a pink noise generator, a spectrum analyzer and so on and the circuit arrangement becomes large and complex. Further, it is troublesome to set the measured compensating amount at the digital graphic equalizer and the circuit arrangement of a control circuit becomes more complicated.

Objects and summary of the invention

Accordingly, it is an object of this invention to provide an improved digital graphic equalizer.

It is another object of this invention to provide a digital graphic equalizer having a digital signal processor to digitally process a pink noise generator and a spectrum analyzer.

It is a further object of this invention to provide a digital graphic equalizer having at least two digital signal processing units in which a digital signal is delayed by a predetermined timing, this digital signal is multiplied with a desired coefficient and this signal with the coefficient multiplied is added to the above original digital signal in feedforward mode or feedback mode to produce a desired filter characteristic, wherein the first digital signal processing unit produces a pink noise with the predetermined filter characteristic and the second digital signal processing circuit uses the desired filter characteristic to carry out the spectrum analysis of the signal to thereby produce a sound field compensating characteristic.

The present invention provides for a digital graphic equalizer comprising a measuring noise generator producing a measuring noise with specific frequency characteristic, means for emitting said measuring noise in a listening environment, means for detecting said measuring noise, the frequency response of which is changed in said listening environment, analog-to-digital converter means supplied with said detected measuring noise and producing digital signals representing the amplitude of said detected measuring noise, spectrum analyzer means for receiving said digital signals from said analog-to-digital converter means for analysing the frequency response of the detected noise which is characterized in that said measuring noise generator is associated with one channel of a two-channel audio-system and comprises a pulse sequence generator for producing a sequence of pulse signals and first digital signal processor means supplied with said sequence of pulse signals and digitally filtering the sequence of said pulse signals which processed pulse signals are then supplied to a digital-to-analog converter so as to produce said measuring noise, and in that said spectrum analyser means is associated with the other channel of said audio-system and consists of a second digital signal processor means supplied with the digital signal from said analog-to-digital converter means and producing a plurality of frequency-divided signals for analysing the frequency response of the detected noise.

Other objects, features and advantages of the present invention will become apparent from the following description taken in conjunction with the attached drawings.

Brief description of the drawings

Figure 1 is a circuit block diagram showing an example of the prior art digital graphic equalizer;

Figure 2 is a graph showing a control characteristic of the digital graphic equalizer of Figure 1;

Figure 3 is a circuit block diagram showing an embodiment of the digital graphic equalizer according to this invention; and

Figures 4 to 6 are respectively circuit block diagrams each showing a main part of the embodiment of the present invention.

Description of the preferred embodiment

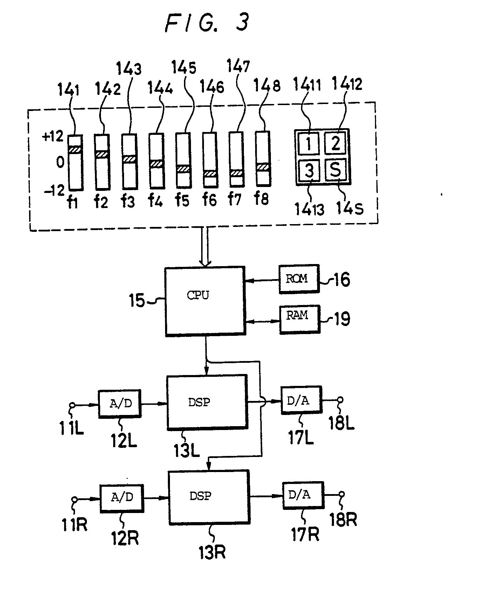

Figure 3 schematically illustrates an embodiment of the digital graphic equalizer according to this invention. In Figure 3, left and right stereophonic audio signals, for example, applied to input terminals 11L and 11R are respectively supplied to A/D (analog-to-digital) converters 12L and 12R and the digitized signals therefrom are respectively supplied to digital signal processing units (hereinafter simply referred to as DSPs) 13L and 13R. By the way, each of the DSPs 13L and 13R incorporates in practice though not shown a multiplier, an adder, a shift register and so on.

A digital signal indicative of the adjusting position from each of volume adjusters $14_1$, $14_2$ ... $14_8$, each of which serves as means for adjusting, for example, an equalizer characteristic, is supplied to a host CPU (central processing unit) 15. In accordance with each of the signals from these volume adjusters $14_1$ to $14_8$, the coefficient (K, a and b) necessary for the equalizing characteristics is retrieved from a ROM (read only memory) 16 which serves as a coefficient table and the coefficient is supplied to the DSPs 13L and 13R, respectively.

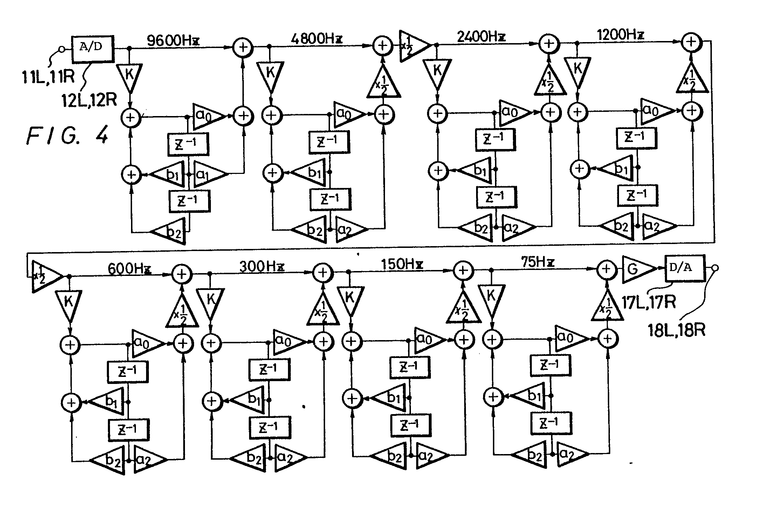

In each of the DSPs 13L and 13R, the calculation is carried out in accordance with a command memory stored therein and the calculation corresponding to a block diagram as, for example, shown in Figure 4 is carried out. The circuit of Figure 4 is equivalent to the circuit formed by connecting in cascade the circuits of Figure 1 in 8 stages, in which frequency characteristics are compensated for with 9600 Hz, 4800 Hz, 2400 Hz, 1200 Hz, 600 Hz, 300 Hz, 150 Hz and 75 Hz supplied thereto as varying points from the input side. The compensating levels are controlled by the coefficients (K, a and b) obtained by the values from the volume adjusters $14_1$ to $14_8$.

Turning back to Figure 3, the output signals from the DSPs 13L and 13R are respectively supplied to D/A (digital-to-analog) converters 17L and 17R and the converted analog signals therefrom are respectively delivered to output terminals 18L and 18R.

Further, in this digital graphic equalizer, a RAM (random access memory) 19 is provided in association with the host CPU 15, and also push buttons $14_{11}$ to $14_{13}$ for presetting are provided to select a desired address region of the RAM 19. Together with the push buttons $14_{11}$ to $14_{13}$, there is provided a push button 14S for set-controlling upon presetting the sound field characteristic.

When the set-controlling push button 14S is depressed, the mode for measuring the sound field is carried out in each of the DSPs 13L and 13R.

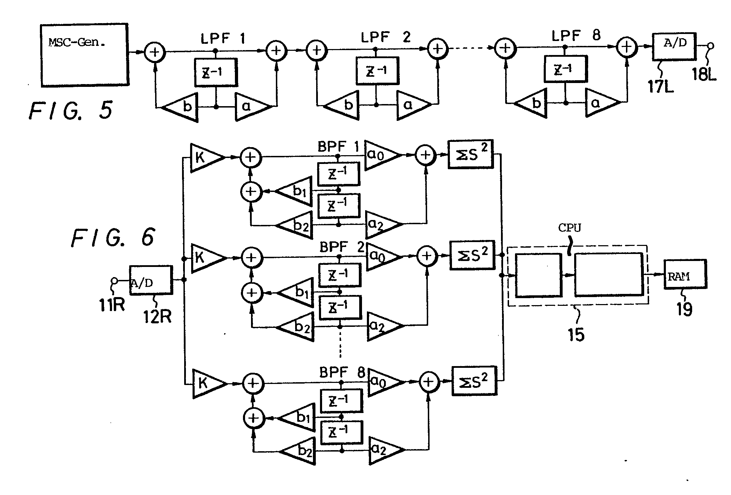

In the sound field characteristic measuring mode, the first DSP 13L generates pink noise. Figure 5 is a circuit block diagram showing an example therefor. In Figure 5, an M-sequence code generator generates a signal of a so-called M-sequence code noise and for producing the desired pink noise this signal is supplied to a filter the frequency response of which is −3 dB/oct. In this case, the M-sequence code generator is operated to generate the pink noise by controlling a shift register (not shown) of the first DSP 13L and the filter having the frequency response of −3 dB/oct. is formed by connecting, for example, 9 filters in cascade similarly to the above-described graphic equalizer.

The pink noise thus generated is supplied to and converted to the analog signal by the D/A converter 17L. This analog signal is supplied through an output terminal 18L to a loudspeaker (not shown) from which it is emitted.

The second DSP 13R carries out the spectrum analysis. Figure 6 is a circuit block diagram showing the circuit therefor. In Figure 6, the signal collected by a microphone (not shown) is supplied through the input terminal 11R to the A/D converter 12R and converted to a digital audio signal. The digital audio signal is supplied to the second DSP 13R.

In the DSP 13R, band-pass filters (BPFs) with frequencies corresponding to those of the frequencies $f_1$ to $f_8$ are provided in parallel to one another. The outputs from these band-pass filters are respectively squared and then processed. In other words, when the digital values contain positive and negative data, the absolute value is obtained by squaring the digital values. In this case, the band-pass filter of Figure 6 is formed similar to the above-described graphic equalizer and the product is carried out by using a shift register, the adder and so on as those incorporated in the DSP 13R.

When one of the product values reaches a predetermined value, all the product calculations are stopped and each of the product values at that time is detected. In this case, each product value corresponds to the acoustic characteristic of the place where the loudspeaker and the microphone are located.

These product values are supplied to the host CPU 15 and the host CPU 15 carries out a logarithmic compression and a compensating spectrum characteristic conversion. The converted values are written in the RAM 19 at its addresses selected by the push buttons $14_{11}$ to $14_{13}$. The values to be written correspond to the values from the volume adjusters $14_1$ to $14_8$.

As described above, the acoustic characteristic is measured and the value corresponding to the compensating characteristic is written in the RAM 19. Accordingly, when the push buttons $14_{11}$ to $14_{13}$ are depressed next, the values written in the RAM 19 at the respective addresses specified by the push buttons $14_{11}$ to $14_{13}$ are read out therefrom and then used to retrieve the coefficient table of the ROM 16. The derived coefficients therefrom are set to the DSPs 13L and 13R, and the DSPs 13L and 13R carry out the graphic equalizer operation according to the sound field compensating characteristic.

According to the digital graphic equalizer of this invention, since the DSPs 13L and 13R are used to generate the pink noise and to carry out the spectrum analysis, it is possible to measure the acoustic characteristic without providing any special or new circuit arrangement. Further, the compensating characteristic is automatically set to the RAM 19 and then read out therefrom to thereby carry out the sound field compensation with ease. Furthermore, for example, since the sound field compensating characteristic of the interior room of a vehicle is written in the RAM 19 at its address selected by the push button $14_{11}$ and the sound field compensating characteristic of the room is written in the RAM 19 at its addresses selected by the push button $14_{12}$, it is possible to obtain the desired characteristics by only depressing the push button $14_{11}$ or $14_{12}$ as required, thus the usefulness of the digital graphic equalizer for users is additionally improved.

Further, with the above-mentioned digital graphic equalizer, the signal processing is all carried out in a digital signal format so that the control by the digital graphic equalizer is accurate. Furthermore, since the signal processing of the graphic equalizer itself, the pink noise generation and the spectrum analysis are all carried out by the same hardware, the circuit arrangement can be made small in scale and simple in construction. In addition, since the digital graphic equalizer of this invention is advantageous in respect of space and manufacturing cost and at the same time, since the content of the signal processing is determined by software, the digital graphic equalizer of this invention can be designed with much flexibility and is suitable for mass-production.

**Claims**

1. A digital graphic equalizer comprising:
—a measuring noise generator (13L) producing a measuring noise with specific frequency characteristic;
—means (17L, 18L) for emitting said measuring noise in a listing environment;
—means for detecting said measuring noise, the frequency response of which is changed in said listing environment;
—analog-to-digital converter means (12L) supplied with said detected measuring noise and producing digital signals representing the amplitude of said detected measuring noise;
—spectrum analyser means (13R, 15, 16, 19) for receiving said digital signals from said analog-to-digital converter means for analysing the frequency response of the detected noise characterized in that

—said measuring noise generator is associated with one channel of a two-channel audio-system and comprises a pulse sequence generator for producing a sequence of pulse signals and first digital signal processor means (Figure 4) supplied with said sequence of said pulse signals and digitally filtering the sequence of said pulse signals, which processed pulse signals are then supplied to a digital-to-analog converter (17L) so as to produce said measuring noise, and in that

—said spectrum analyser means is associated with the other channel of said audio-system and consists of a second digital signal processor means supplied with the digital signal from said analog-to-digital converter means (12R) and producing a plurality of frequency-divided signals for analysing the frequency response of the detected noise.

2. A digital graphic equalizer according to claim 1, in which said first digital signal processor means produces a measuring noise the frequency response of which equals −3 dB/oct.

3. A digital graphic equalizer according to claim 2, in which said measuring noise is a pink noise.

4. A digital graphic equalizer according to claim 3, in which said pulse-sequence generator is a M-sequence code generator.

5. A digital graphic equalizer according to claim 1, in which said first digital signal processor means comprises cascade-connected low-pass filters.

6. A digital graphic equalizer according to claim 5, in which each of said low-pass filters comprises an input adder having first and second input terminals and an output terminal, the first input terminal of which is supplied with the output of said M-sequence code generator; an output adder having first and second input terminals and an output terminal; and delay circuit means having an input terminal connected to the output terminal of said input adder and the first input terminal of said output adder, the output terminal of which is connected to the second terminals of said input and output adders through first and second multipliers, respectively.

7. A digital graphic equalizer according to claim 1, in which said spectrum analyzer means includes a logarithmic compressor.

8. A digital graphic equalizer according to claim 1, further including a memory (19) for storing said compensating characteristics.

9. A digital graphic equalizer according to claim 8, in which said memory is a random access memory.

**Patentansprüche**

1. Digitaler graphischer Entzerrer mit:

—einem Rauschsignalgenerator (13L) zur Erzeugung eines Meßrauschens mit spezifischem Frequenzgang;

—Einrichtungen (17L, 18L) zum Abstrahlen des Meßrauschens in ein Hörumfeld;

—Einrichtungen zum Erfassen des Meßrauschens, dessen Frequenzantwort vom Hörumfeld geändert ist;

—einem Analog-Digital-Wandler (12L), dem das erfaßte Meßrauschen zugeführt ist, zur Erzeugung von die Amplitude des erfaßten Meßrauschens darstellenden digitalen Signalen;

—einem Spektrum-Analysator (13R, 15, 16, 19), der die digitalen Signale vom Analog-Digital-Wandler empfängt, zum Analysieren der Frequenzantwort des erfaßten Meßrauschens, dadurch gekennzeichnet, daß

—der Rauschsignalgenerator einem Kanal eines Zweikanaltonsystems zugeordnet ist und einen Puls-Generator enthält zur Erzeugung einer Folge von Impulssignalen und einen ersten Prozessor zur Verarbeitung und digitalen Filterung (Fig. 4) der Impulssignalfolge aufweist, dessen Ausgang einen Digital-Analog-Wandler (17L) speist zur Erzeugung des Meßrauschens, und daß

—der Spektrum-Analysator dem anderen Kanal des Zweikanaltonsystems zugeordnet ist und aus einem zweiten Prozessor für digitale Signale besteht, dem das digitale Signal vom Analog-Digital-Wandler (12R) zugeführt wird und der eine Mehrzahl von frequenzunterteilten Signalen erzeugt zum Analysieren der Frequenzantwort des erfaßten Meßrauschens.

2. Digitaler graphischer Entzerrer nach Anspruch 1, dadurch gekennzeichnet, daß der erste Prozessor für digitale Signale ein Meßrauschen erzeugt, dessen Frequenzantwort gleich −3 dB/oct ist.

3. Digitaler graphischer Entzerrer nach Anspruch 2, dadurch gekennzeichnet, daß als Meßrauschen Rosa-Rauschen verwendet wird.

4. Digitaler graphischer Entzerrer nach Anspruch 3, dadurch gekennzeichnet, daß der Puls-Generator ein Generator zur Erzeugung eines M-Reihencodes ist.

5. Digitaler graphischer Entzerrer nach Anspruch 1, dadurch gekennzeichnet, daß der erste Prozessor eine Tiefpaßfilterkaskade aufweist.

6. Digitaler graphischer Entzerrer nach Anspruch 5, dadurch gekennzeichnet, daß jedes Tiefpaßfilter

—eine Eingangsaddierer mit ersten und zweiten Eingangsanschlüssen und einem Ausgangsanschluß, wobei der erste Eingangsanschluß mit dem Ausgang des M-Reihencode-Generators gespeist ist;

—einen Ausgangsaddierer mit ersten und zweiten Eingangsanschlüssen und einem Ausgangsanschluß;

—eine Verzögerungsschaltung enthält, deren Eingangsanschluß mit dem Ausgangsanschluß des Eingangsaddierers und mit dem ersten Eingangsanschluß des Ausgangsaddierers und deren Ausgangsanschluß jeweils über erste und zweite Multiplizierer mit den zweiten Eingangsanschlüssen des Eingangs- bzw. des Ausgangsaddierers verbunden ist.

7. Digitaler graphischer Entzerrer nach Anspruch 1, dadurch gekennzeichnet, daß der Spektrum-Analysator einen logarithmischen Komprimierer enthält.

8. Digitaler graphischer Entzerrer nach Anspruch 1, gekennzeichnet durch einen Speicher (19) zum Abspeichern von Kompensationskenndaten.

9. Digitaler graphischer Entzerrer nach Anspruch 8, dadurch gekennzeichnet, daß der Speicher ein Speicher mit wahlfreiem Zugriff (RAM) ist.

**Revendications**

1. Egaliseur numérique graphique comprenant:

—un générateur (13L) d'un bruit de mesure créant un bruit de mesure ayant une caractéristique spécifique en fréquences,

—un dispositif (17L, 18L) destiné à émettre le bruit de mesure dans un environnement d'écoute,

—un dispositif de détection du bruit de mesure dont la réponse en fréquences est modifiée dans l'environnement d'écoute,

—un convertisseur analogique-numérique (12L) recevant le bruit détecté de mesure et créant des signaux numériques représentant l'amplitude du bruit détecté de mesure,

—un analyseur de spectre (13R, 15, 16, 19) destiné à recevoir les signaux numériques du convertisseur analogique-numérique et à analyser la réponse en fréquences du bruit détecté, caractérisé en ce que:

—le générateur de bruit de mesure est associé à un canal d'un système d'audiofréquences à deux canaux et comporte un générateur de séquence d'impulsions destiné à créer une séquence de signaux pulsés et un premier dispositif à processeur numérique de signaux (figure 4) recevant la séquence de signaux pulsés et filtrant numériquement la séquence de signaux pulsés, les signaux pulsés traités étant alors transmis à un convertisseur numérique-analogique (17L) afin que le bruit de mesure soit formé, et en ce que:

—l'analyseur de spectre est associé à l'autre canal du système d'audiofréquences et comporte un second dispositif à processeur numérique de signaux recevant le signal numérique du convertisseur analogique-numérique (12R) et créant plusieurs signaux répartis dans des bandes de fréquences afin que la réponse en fréquences de bruit détecté soit analysée.

2. Egaliseur numérique graphique selon la revendication 1, dans lequel le premier dispositif à processeur numérique de signaux crée un bruit de mesure dont la réponse en fréquences est égale à −3 dB par octave.

3. Egaliseur numérique graphique selon la revendication 2, dans lequel le bruit de mesure est un bruit rose.

4. Egaliseur numérique graphique selon la revendication 3, dans lequel le générateur de séquence d'impulsions est un générateur de code de séquence M.

5. Egaliseur numérique graphique selon la revendication 1, dans lequel le premier dispositif à processeur numérique de signaux comporte des filtres passe-bas montés en cascade.

6. Egaliseur numérique graphique selon la revendication 5, dans lequel chacun des filtres passe-bas comporte un additionneur d'entrée ayant une première et une seconde borne d'entrée et une borne de sortie, la première borne d'entrée recevant le signal de sortie du générateur de code de séquence M, un additionneur de sortie ayant une première et une seconde borne d'entrée et une borne de sortie, et un circuit à retard ayant une borne d'entrée reliée à la borne de sortie de l'additionneur d'entrée et à la première borne d'entrée de l'additionneur de sortie, sa borne de sortie étant reliée aux secondes bornes des additionneurs d'entrée et de sortie par l'intermédiaire d'un premier et d'un second circuit multiplicateur respectivement.

7. Egaliseur numérique graphique selon la revendication 1, dans lequel l'analyseur de spectre comporte un circuit de compression logarithmique.

8. Egaliseur numérique graphique selon la revendication 1, comprenant en outre une mémoire (19) destinée à mémoriser les caractéristiques de compensation.

9. Egaliseur numérique graphique selon la revendication 8, dans lequel la mémoire est une mémoire à accès direct.

*F I G. 1*

*F I G. 2*

1

## FIG. 3

F I G. 4

11L,11R  12L,12R  A/D

17L,17R  18L,18R  D/A  G

9600Hz  4800Hz  2400Hz  1200Hz

600Hz  300Hz  150Hz  75Hz

## FIG. 5

MSC-Gen.

LPF 1   LPF 2   LPF 8

$Z^{-1}$   $Z^{-1}$   $Z^{-1}$

b   a   b   a   b   a

A/D

17L   18L

## FIG. 6

BPF 1   $a_0$   $\Sigma S^2$

K   $Z^{-1}$   $b_1$

$Z^{-1}$   $b_2$   $a_2$

BPF 2   $a_0$   $\Sigma S^2$

K   $Z^{-1}$   $b_1$

$Z^{-1}$   $b_2$   $a_2$

BPF 8   $a_0$   $\Sigma S^2$

K   $Z^{-1}$   $b_1$

$Z^{-1}$   $b_2$   $a_2$

A/D

11R   12R

CPU

RAM

15   19